# EUROPEAN PATENT APPLICATION

(11) **EP 2 476 896 A1**
(43) Date of publication of application: **18.07.2012**
(21) Application number: 11150848.7
(22) Date of filing: 13.01.2011
(51) Int. Cl.: F02M 63/00, H01L 41/053

(54) **Actuator arrangement for use in a fuel injector**

(71) Applicant: Delphi Automotive Systems Luxembourg SA, 4940 Bascharage (LU)
(72) Inventor: Baudry, Xavier, 6860, Assenois (BE); Kolkman, Manfred, 6780, Messancy (BE)
(74) Representative: Office Freylinger

(57) **Abstract**

The invention discloses an actuator arrangement (10) for use in a fuel injector, comprising:
• a piezoelectric actuator having a body section (12), said body section having a first end piece (14) and a second end piece (16);
• an encapsulation member (24) which encloses the body section between the end pieces secured thereon, wherein potting material (34) is fitted between the encapsulation member and the body section, wherein the encapsulation member has a corrugated bellows form comprising a plurality of corrugations over its entire length
• wherein said second end piece comprises a ball-joint (40) having a central opening (50) which is sealed after the potting material has been introduced into the encapsulation member.
The invention also discloses a process for assembling said actuator arrangement.

## Description

### Technical field

The present invention relates to an actuator arrangement for use in a fuel injector of the type intended for use in a fuel system of an internal combustion engine. The invention relates, more particularly, to an encapsulation of an actuator arrangement of a fuel injector of the accumulator or common rail type, the fuel injector being of the type controlled using a piezoelectric actuator.

### Background Art

It is known to use piezoelectric actuators in fuel injectors of internal combustion engines. Such piezoelectrically operable fuel injectors provide a high degree of control over the timing of injection events within the combustion cycle and the volume of fuel that is delivered during each injection event. This permits improved control over the combustion process, which is essential in order to keep pace with increasingly stringent worldwide environmental regulations. Such fuel injectors may be employed in compression ignition (diesel) engines or spark ignition (petrol) engines.

A typical piezoelectric actuator unit designed for use in an automotive fuel injector has a stack structure formed from an alternating sequence of piezoelectric elements or layers and planar internal electrodes. The piezoelectric layers, in turn, form an alternating sequence of oppositely polarized layers, and the internal electrodes form an alternating sequence of positive and negative internal electrodes. The positive internal electrodes are in electrical connection with a first external electrode, hereinafter referred to as the positive side electrode. Likewise, the internal electrodes of the negative group are in electrical connection with a second external electrode, hereinafter referred to as the negative side electrode.

If a voltage is applied between the two external electrodes, the resulting electric fields between each adjacent pair of positive and negative internal electrodes cause each piezoelectric layer, and therefore the piezoelectric stack, to undergo a strain along its length, i.e. along an axis normal to the plane of each internal electrode. Because of the polarization of the piezoelectric layers, it follows that not only can the magnitude of the strain be controlled by adjusting the applied voltage, but also the direction of the strain can be reversed by switching the polarity of the applied voltage. Rapidly varying the magnitude and/or polarity of the applied voltage causes rapid changes in the strength and/or direction of the electric fields across the piezoelectric layers, and consequentially rapid variations in the length of the piezoelectric actuator. Typically, the piezoelectric layers of the stack are formed from a ferroelectric material such as lead zirconate titanate (PZT).

Such an actuator is suitable for use in a fuel injector, for example of the type known from the present Applicant's European Patent No. EP 0 995 901. The fuel injector is arranged so that a change in length of the actuator results in a movement of a valve needle. The needle can be thus raised from or lowered onto a valve seat by control of the actuator length so as to permit a quantity of fuel to pass through drillings provided in the valve seat.

In use, the actuator of such a fuel injector is surrounded by fuel at high pressure. The fuel pressure may be up to or above 2000 bar. In order to protect the piezoelectric actuator from damage and potential failure, the piezoelectric actuator must be isolated from this environment by at least a layer of barrier material, herein referred to as 'encapsulation member'. It is known to encapsulate the piezoelectric actuator with an inert fluoropolymer, for example as described in the Applicant's PCT published Patent Application No. WO02/061856A1 (EP 1356529 A), which acts to prevent permeation of liquid fuel, water and contaminant substances dissolved in the water or fuel, into the structure of the actuator.

It has been observed, however, that there may still be ingress of fluid into the interface between the actuator and the polymeric sleeve. This either through the wall of the encapsulation member or via its ends.

In a further process, it has been proposed to use a metal tube around the piezoelectric actuator. In EP 1 956 229 A1, the applicant discloses such metal tube for the encapsulation of piezoelectric actuators wherein the metallic tube comprises two types of strain compensation formations, the formations can be extended parallel to the longitudinal axis and the second formations deflected inwardly transversally to the longitudinal axis of the piezoelectric actuator.

EP1 854 996 describes a piezoelectric actuator arrangement for a fuel injector that includes a corrugated metal enclosure surrounding the piezoelectric stack and containing a passivation liquid in contact with the stack. Said piezoactuator for injecting fuel with a predetermined fuel pressure has an at least laterally narrowing casing around the internal space of the actuator which has a first temperature and/or pressure-dependent volume change, a piezo stack located in the internal space which has a second temperature and/or pressure-dependent volume change, a transmission element which is located between the piezo stack and the casing for transmitting the fuel pressure on the outside of the casing onto the piezo stack, wherein the transmission element has a passivation liquid which has a third temperature- and/or pressure-dependent volume change as well as several preformed bodies which have a fourth temperature- and/or pressure-dependent volume change; wherein the relation between the passivating liquid and the preformed bodies is set that the first volume change of the casing basically corresponds to an overall internal space volume change which has at least the second, third, and fourth volume change.

Against this background, the main object of the present invention is to provide an alternative encapsulation that, when applied to a piezoelectric actuator, greatly reduces fuel (diesel/gasoline) and water permeation and thus improves the lifetime of piezoelectrically driven injectors.

### Summary of the Invention

This object is achieved by an actuator arrangement for use in a fuel injector, comprising:
- a piezoelectric actuator having a body section, said body section having a first end piece and a second end piece;
- an encapsulation member which encloses the body section between the end pieces secured thereon, wherein potting material is fitted between the encapsulation member and the body section, wherein the encapsulation member has a bellow-type form comprising a plurality of corrugations over its entire length
- wherein said second end piece comprises a ball-joint having a central opening which is sealed after the potting material has been introduced into the encapsulation member.

The above actuator arrangement for use in a fuel injector as described above greatly reduces fuel (diesel/gasoline) and water permeation and thus improves the lifetime of piezoelectrically driven injectors because it is now possible to perform a leak check on the interfaces between the encapsulation member, which encloses the body section and the end pieces, which might lead to quality problems in the future. Indeed, the fastening between the encapsulation member, which encloses the body section and both end pieces are already made before the potting material is fitted between the encapsulation member and the body section. Furthermore, the above actuator arrangement is suitable for high volume production.

On the actuator arrangements for use in a fuel injector, the potting material is dispensed in a cavity of the actuator arrangement situated between the piezoelectric stack and the encapsulation member- while holding the actuator arrangement upside down - from the ball-joint end of the actuator arrangement, said ball-joint being already secured to the encapsulation member. The potting material is dispensed in the encapsulation member through the central opening in the ball-joint.

A further advantage of the present actuator arrangements is that the contamination of the securing interfaces with potting material residues is avoided since the potting material is filled into the actuator arrangements through the central opening in the ball-joint after it has been secured to the encapsulation member. Bad securing interfaces with voids are avoided since no residues of the potting material can contaminate the interfacing surfaces.

The ball-joint is preferably welded to said encapsulation member.

The central opening of the ball-joint is preferably sealed by introducing a sealing plug in the central opening of said ball-joint.

The sealing plug is preferably press-fitted into the central opening of the ball-joint.

The sealing plug comprises, in a preferred embodiment, an elastomeric disc, which is inserted between the sealing plug and the filler material.

The sealing plug comprises, in an alternative embodiment, a plug sleeve.

The sealing plug may additionally be secured in the ball-joint by welding.

The encapsulation member comprises preferably a metallic tube made of steel, stainless steel, nickel or one of their alloys.

The encapsulation member preferably has a low thickness to obtain a minimum axial stiffness. The thickness will be in the range of 0.02 to 0.2 mm preferably of about 0.1 mm.

To further reduce the axial stiffness of the encapsulation member, the number of corrugations, as well as their depth, measured from peak to bottom, will be maximized within given packaging and manufacturability constraints. The corrugations of the encapsulation member preferably have a depth measured from peak to bottom ranging from 1.2 to 0.6 mm.

The corrugations of the encapsulation member preferably have a length measured from peak to peak ranging from 0.8 to 1.5 mm.

The manufacture of the bellows of the encapsulation member would typically be done by plastic deformation of a tube by processes such as hydroforming, but it could also be formed by an electro-deposition process.

The potting material is preferably selected from the group consisting of rubber, preferably a silicone or a fluorosilicone rubber, silicone, a polymer preferably a silicone resin or an epoxy resin. The potting material preferably further comprises >50% w/w of mineral particles. These mineral particles are selected from the group consisting of a powder, preferably of silica or of metal oxides such as alumina.

To prevent that the pressurized fuel leads to collapsing (buckling) of the bellow tube, the cavity between the encapsulation member and the body section needs to be fully filled with a potting material having a relative high bulk modulus.

A mineral filled epoxy resin has proven to be suitable for this purpose

The at least one corrugation of the encapsulation member preferably overlaps an edge of said end piece.

According to a further aspect, the present invention concerns a process for assembling an actuator arrangement for use in a fuel injector comprising:
- a piezoelectric actuator having a body section, said body section having a piezoelectric stack, a first end piece and a second end piece;
- an encapsulation member which encloses the body section between the end pieces secured thereon, wherein the encapsulation member has a corrugated bellows form comprising a plurality of corrugations over its entire length,
- said second end piece comprises a ball-joint having a central opening,
- wherein potting material is filled through the central opening of said second end piece between the encapsulation member and the body section and
- wherein the central opening is sealed after the potting material has been introduced into the encapsulation member.

The ball-joint is preferably welded to said encapsulation member before the potting material is filled through the central opening of the second end piece while holding the actuator arrangement upside down, i.e. the second end piece facing up and the first end piece facing down.

In a further preferred embodiment, the potting material is introduced into the cavity through the central opening of the second end piece and through a first side hole in the second end piece whereas the gas (generally air) escapes or is withdrawn from a second side hole in the second end piece. The potting material is dispensed preferably from a pressurized reservoir through a needle having a bended end-tip, so that the bended end-tip is introduced in the first side hole of the end piece. The potting material gradually fills the entire cavity between the encapsulation member and the body section whereas the gas contained in the cavity is evacuated through the second side hole of the end piece.

In an alternative process for assembling an actuator arrangement, the potting material is introduced into the encapsulation member by creating a vacuum i.e. by removing the gas completely or partly from the cavity between the encapsulation member and the body section.

In said alternative process, a pressurized reservoir containing a potting material is connected via a first tube having a first valve to the central opening of the second end piece, a vacuum pump is connected via a second tube having a second valve to the central opening of the second end piece, wherein in a first step, said first valve is closed and said second valve is opened and gas contained in the piezoelectric actuator arrangement is withdrawn from the piezoelectric actuator arrangement, wherein in a second step, said second valve is closed and said first valve is opened so that the potting material contained in said reservoir is transferred through said central opening in the second end piece in a space contained between the encapsulation member and the body section.

In yet another alternative process for assembling an actuator arrangement, the piezoelectric actuator arrangement is transferred in a pressure chamber which is then depressurized, the potting material is dispensed into the piezoelectric actuator arrangement between the encapsulation member and the body section and wherein the piezoelectric actuator arrangement is then re-pressurized to ambient pressure and transferred out of the pressure chamber.

The actuator arrangement for use in a fuel injector as described above greatly reduces the risk of fuel or water permeation, since the encapsulation barrier is made out of metal parts that are joined by welding and press-fitting, both being proven sealing techniques. Since the encapsulation member is joined to the actuator end pieces prior to potting, it is possible to perform a leak check on the welded structure and detect any quality issue at an early stage.

### Brief Description of the Drawings

Further details and advantages of the present invention will be apparent from the following detailed description of several not limiting embodiments with reference to the attached drawings, wherein:
Figure 1 is a side view of a known piezoelectric actuator arrangement;
Figure 2 is a cross sectional view of a piezoelectric actuator arrangement of Figure 1 at line A-A;
Figure 3 is a longitudinal section of Figure 1 showing the ball-joint;
Figure 4 is a longitudinal section of a piezoelectric actuator arrangement according to a preferred embodiment of the invention;
Figure 5 is a perspective view of a ball-joint used in Figure 4,
Figure 6 is a longitudinal view of a piezoelectric actuator arrangement according to a further preferred embodiment of the invention;
Figure 7 is a cross sectional view of the ball-joint end of the piezoelectric actuator arrangement of Figure 6;
Figure 8 is a cross sectional view of the ball-joint end of a further preferred piezoelectric actuator arrangement;
Figure 9 is a schematic view of a first process for filling the cavity of a piezoelectric actuator arrangement with potting material;
Figure 10 is a schematic view of a second process for filling the cavity of a piezoelectric actuator arrangement with potting material.

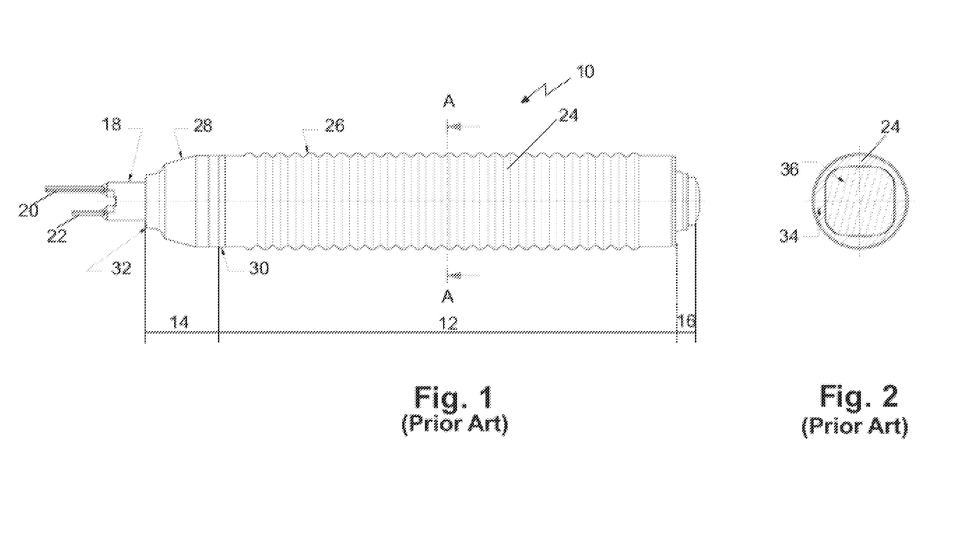

The actuator arrangement 10 as shown in the side view of Figure 1 includes a generally cylindrical body section 12, comprising: a central major portion containing a piezoelectric stack, and first and second end pieces 14 and 16 respectively. End piece 14, at the first end of the body section 12, includes an electrical connector 18 with first and second terminals 20, 22, which in use receives a voltage from a voltage supply (not shown). End piece 16, at the second end of the body section 12, includes a load transmitting member, commonly called ball-joint, which in use cooperates with a control piston or valve needle (not shown) of the fuel injector.

Details of the piezoelectric stack and internal components of actuator 10 and a description of how the actuator operates are disclosed fully in the Applicant's granted patent EP 0 995 901, so will not be discussed here.

Evident from Figure 1 is the presence of an encapsulation member 24, which envelops the body section 12 and extends along the length of body section 12 from end piece 14 to end piece 16.

The encapsulation member 24 comprises corrugations in a bellows form 26 over its entire length, except where joined to end pieces 14, 16. The encapsulation member 24 would typically be made of a stainless steel alloy. As can be seen on the figures, the corrugations 26 form a regular pattern and show no sharp edges.

The first end piece 14 comprises an adapter 28 fixed to the encapsulation member 24 by a first weld 30 and fixed to the electrical connector 18. The sealing of the adapter with regard to the encapsulation member is made by the first weld 30 and with regard to the electrical connector 18 by a sealing 32 in the form of e.g. an O-ring or the like.

Figure 2 shows a cross section through the actuator arrangement 10 of Figure 1 along the line A-A. The cross-section of the encapsulation member 24 bellows is substantially circular. The encapsulation member 24 surrounds a filler material or potting material 34 and the piezoelectric stack 36. For an actuator 10 to be used inside the high pressure part of a diesel fuel injector, it would be impossible to make an impermeable encapsulation member 24 that is strong enough to resist the pressure without collapsing and at the same time thin enough to permit enough axial displacement of the actuator. For this reason, the potting material 34 must have a high bulk modulus and also completely fill the space between the stack 36 and the encapsulation member 24 so that it can provide a counter-pressure to resist collapsing of the encapsulation member 24. A problem however is that suitable fillers tend to have a thermal expansion coefficient that is higher than that of the piezoelectric stack 36 or the encapsulation member 24. The piezoelectric stack 36 is typically of a generally square shape with chamfered or rounded off corners 38 since it is usually sliced out of a block. When the actuator 10 is heated in use, the filler material 34 expands and thus reduces or removes the required compressive pre-load of the piezo stack. In order to minimize this problem, the thermal expansion coefficient of filler material 34 must be as low as possible, as well as its volume. The base potting material 34 would either be a rubber such as a silicone or fluorosilicone rubber, or a polymer such as a silicone resin or epoxy resin. The potting material comprises a filler material made of mineral particles such as silica or alumina to further minimize its thermal expansion coefficient and compressibility, and also to increase its thermal conductivity. For example, a silica filled epoxy resin has proven to be suitable for this purpose.

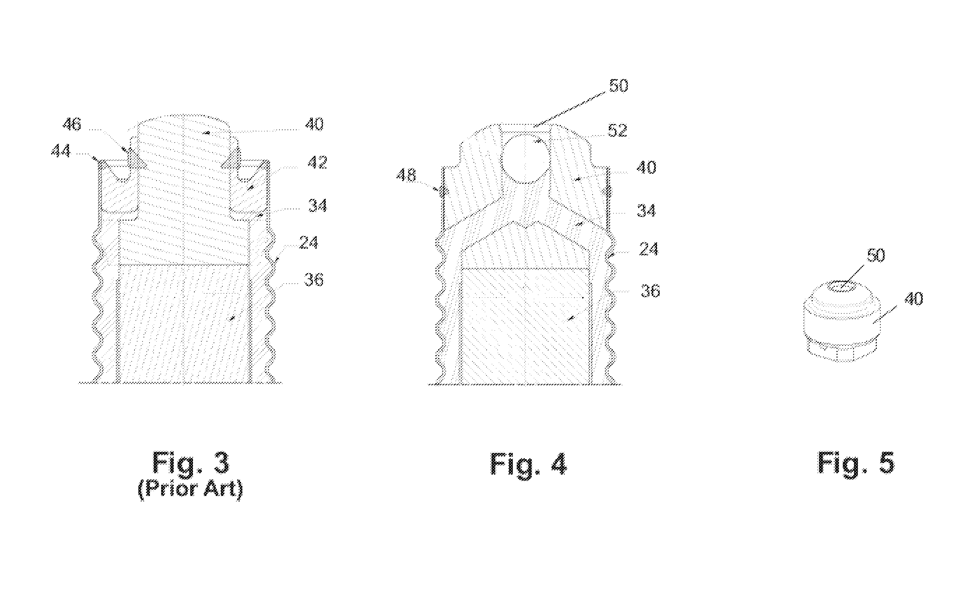

Figure 3 shows a longitudinal section zoomed in on the end of the actuator close to end piece 16. The end piece 16 is made of two parts in this particular case, a ball-joint 40 and a collar 42. The ball-joint 40 is in contact with the piezoelectric stack 36 and is maintained in place by a collar 42 which is welded by a second weld 44 to the encapsulation member 24 and by a third weld 46 to the ball-joint 40. The collar 42 is pushed onto the ball-joint 40 until it is in contact with the filler material 34. The collar 42 is dimensioned so that it fits tightly over the ball-joint 40 and into the encapsulation member 24. The collar 42 is preferably press-fitted on the ball-joint 40 and into the encapsulation member 24.

On the actuator arrangement 10 of Figure 1, the potting material 34, typically an epoxy resin comprising a mineral filler is dispensed in the space between the piezoelectric stack 36 and the encapsulation member 24 from the second end piece 16 of the actuator arrangement 10 while holding the actuator arrangement 10 upside down prior to installation of the collar 42. After heat curing the epoxy resin filler material 34, the collar 42 is pressed on top of the epoxy resin filler material 34, followed by making the two welds 44, 46 to secure the end piece 16 to the encapsulation member 24.

Air pockets could remain between the collar 42 and the cured filler material 34 due to a geometry mismatch, which could lead to encapsulation failure during operation. An elastomeric ring (not shown) may be introduced between the filler material 34 and the collar 42 before fitting the collar 42 onto the ball-joint 40 to compensate the geometrical mismatch between the collar 42 and the menisci shape of the filler material 34 and thus avoid air inclusions in the piezoelectric actuator arrangement.

A problem observed during the assembling and building of the actuator arrangement 10 as shown in Figure 1 was the contamination of the weld interfaces of welds 44, 46 with epoxy resin filler material 34 residues, which resulted in bad welds with voids. Welding problems occurred despite of extensive cleaning operations. Such welding problems lead to quality problems, respectively to a high number of pieces, which fail rapidly during use due to bad welds. Also, with that prior art design and manufacturing process sequence, it is not possible to perform a leak check on the welds 30, 44, 46, so that bad welds cannot be detected easily.

Figure 4 is a longitudinal section of a piezoelectric actuator arrangement 10 according to a preferred embodiment of the invention. It shows a longitudinal section zoomed in on the end of the actuator arrangement close to end piece 16. The end piece 16 is made of only one part (the ball-joint 40 in this particular case), and is press-fitted into the encapsulation member 24. The ball-joint 40 is in contact with the piezoelectric stack 36 and is welded by a single weld 48 to the encapsulation member 24. As can be seen while comparing Figs 3 and 4, the weld 48 on the ball-joint 40 of Figure 4 is much easier to realize because it is easily accessible and lies on the outside of the encapsulation member 24, whereas the two welds 44, 46 of the actuator arrangement of Figure 3 are situated on the collar 42 and more difficult to access and more difficult to realize.

The ball-joint 40 has a central opening 50, which is plugged by a press-fitted sealing plug (in this particular case a ball) 52. It has to be noted that the sealing plug 52 must not necessary be spherical, it may have any form as long as it allows plugging the central opening 50 in the end piece 16 securely.

After the filler material 34 has been introduced in the actuator arrangement, the sealing plug 52 is pushed into the central opening 50 of the ball-joint 40 until it is in contact with the filler material 34. The sealing plug 52 is dimensioned so that it fits tightly into the central opening 50 of the ball-joint 40. The sealing plug 52 is preferably press-fitted into the central opening 50 of the ball-joint 40.

On the actuator arrangement 10 of Figure 4, the potting material 34, typically an epoxy resin comprising a mineral filler, is dispensed in the space between the piezoelectric stack 36 and the encapsulation member 24 through the central opening 50 of the end piece 16 of the actuator arrangement 10 after the ball-joint 40 has been fitted onto the encapsulation member 24 and welded to it, while holding the actuator arrangement 10 upside down. After heat curing the epoxy resin filler material 34, the sealing plug 52 is pressed on top of the epoxy resin filler material 34.

Figure 5 shows a perspective view of the ball-joint 40 of Figure 4.

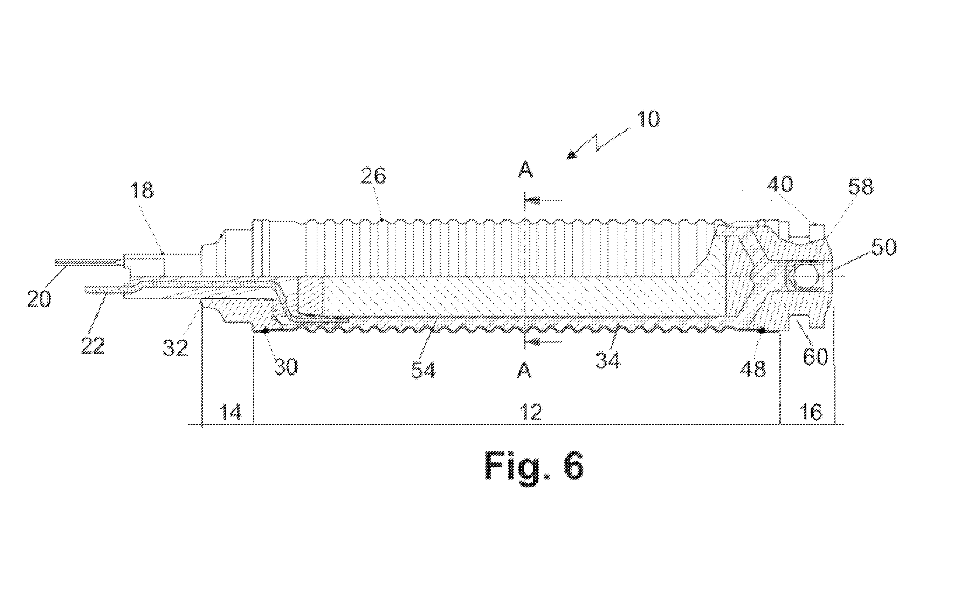

Figure 6 is a longitudinal view of a piezoelectric actuator arrangement according to a further preferred embodiment of the invention. In this figure, the lower half and right hand side of the figure represent a cross-section of a preferred embodiment of a piezoelectric actuator according to the present invention, whereas the upper half of the figure represents the exterior of the piezoelectric actuator arrangement.

In the lower half of Figure 6 representing a cross-section of the actuator arrangement, the electrical connection between the second terminal 22 and the side electrode 54 of the piezoelectric stack 36 is depicted.

When comparing the actuator arrangements 10 of figures 1 and 6, the differences are situated mainly on the second end 16, i.e. the ball-joint 40 end.

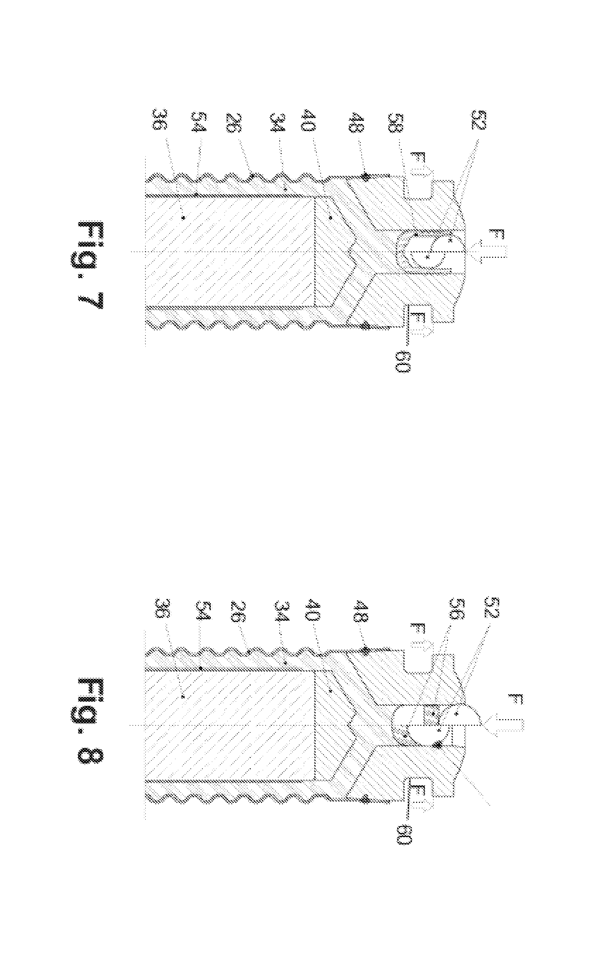

As can be seen when comparing the ball-joints 40 of Figure 4, and Figure 7 to the ball-joint end of Figure 4, the sealing plug 52 situated in the central opening 50 of the ball-joint 40 comprises a plug sleeve 58. The left half of Figure 7 shows the sealing plug 52 before it is press-fitted into the central opening 50, whereas the right half of Figure 7 shows the sealing plug 52 after it is press-fitted into the central opening 50. The plug sleeve 58 used in the piezoelectric actuator arrangement 10 of Figure 7 is known as a "Koenig Expander plug" and is described in more detail in EP 0 364 699. These expander plugs are available from KVT-Koenig GmbH in Germany. Expansion and anchorage of sealing plug 52 in the central opening is achieved by pressing a ball into the plug sleeve 58.

As can be seen when comparing the ball-joints 40 of Figure 8 to the ball-joint end of Figure 4, the sealing plug 52 situated in the central opening 50 of the ball-joint 40 comprises an elastomeric disc 56. This elastomeric disc is pushed against the upper surface of the meniscus of the filler material 34 and eliminates thus any air inclusions between the filler material 34 and the sealing plug 52 and compensates for any irregularities in the surface of the filler material 34 in contact with the sealing plug 52. The sealing plug 52 may be fixed to the ball-joint by a weld applied around the upper circumference of the sealing plug.

The ball-joint of Figure 6, 7 and 8 comprises an annular groove 60 for holding the actuator arrangement while the sealing plug 52 is press-fitted into the central opening 50 of the ball-joint 40. The pushing and supporting force locations during the press-fit operation are indicated by the letter F on theses figures. The annular groove 60 allows thus to eliminate excessive pressure transmitted to the piezoelectric stack 36 during the press-fit operation.

The main changes in the proposed piezoelectric actuator arrangement 10 of Figures 4 - 8 with regard to the piezoelectric actuator arrangement 10 of Figure 1 are that 1) only one weld has to be made at the level of the ball-joint, 2) the weld 48 is made prior to epoxy resin filling i.e. at the same time as the weld 30 at the level of the first end piece 14, 3) the collar is replaced by a sealing plug. The fact that the welds 30 and 48 can be made in one single process step i.e. at the same time, saves time and costs in the manufacturing process. Indeed with the prior art configuration as shown in Figure 1, the weld 30 at the first end 14 had to be made first and then the filler material 34 had to be introduced into the piezoelectric actuator arrangement 10 and then only the collar 42 of the second end piece 16 could be fitted onto the piezoelectric actuator arrangement and the welds 44, 46 be made. The actuator arrangement according to Figure 1 has to be brought to the welding station twice whereas the actuator arrangement of the Figures 4 - 8 has to be brought to the welding station only once.

A further advantage of the ball-joint according to the present invention is that the surface of the meniscus, which is inevitably formed on the upper surface of the filler material, is much smaller than the surface of the meniscus of the filler material in the actuator according to the prior art. The risk that air is entrapped between the filler and the ball-joint is thus greatly reduced.

Furthermore, if a plug sleeve 58 or an elastomeric disk 56 is used, the entrapment of air between the sealing plug 52 and the filler material 34 is completely eliminated.

This new construction makes it possible to perform a leak check of the welded encapsulation by pressurizing the inside with a detectible gas like e.g. helium. Leak check can be performed by pressurizing the inside or the outside. What is required is a pressure difference. Leak check can be done by several ways: monitoring pressure drop (nitrogen can be used), monitoring mass flow (nitrogen can be used) or monitoring specific chemical elements (hydrogen or helium can be used). To do so, it is mandatory that the interface at the first end piece is properly sealed, e.g. by using an O-ring.

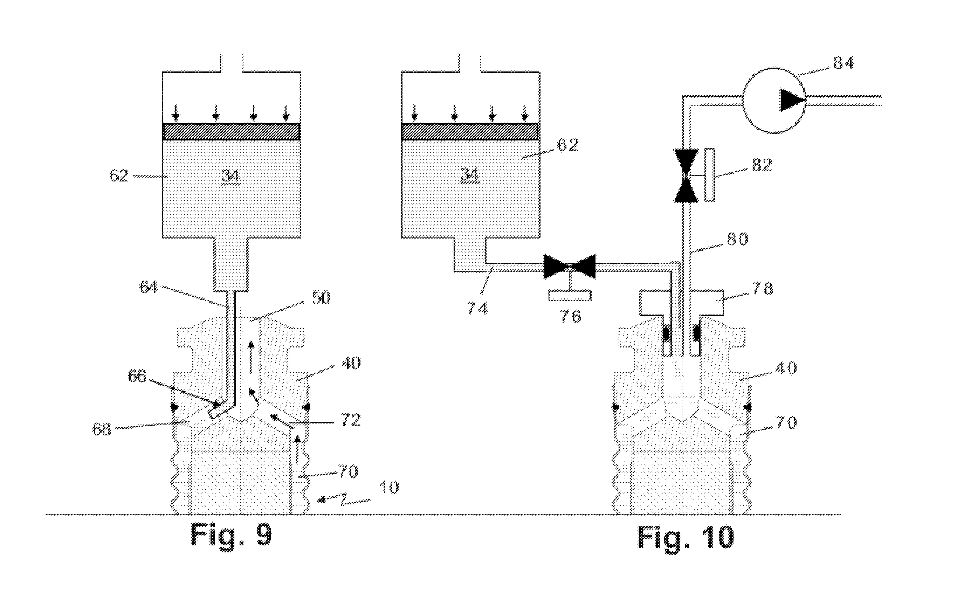

Figures 9 and 10 show two possible potting material filling processes that have been identified: without or with vacuum, i.e. with removal of the air prior to potting material filling by depressurization (vacuum potting).

Figure 9 shows the process of filling the piezoelectric actuator arrangement 10 without vacuum: the filler material 34, an epoxy resin comprising a mineral filler, is dispensed from a pressurized reservoir 62, preferably a syringe (<10 bar) through a needle 64 with bended end-tip 66 into a first side hole 68 of the ball-joint 40. During filling, the air in the cavity 70 of the piezoelectric actuator arrangement 10 can then escape via a second side hole 72 that provides a venting function.

Figure 10 shows a first option of the process of filling the piezoelectric actuator arrangement 10 with vacuum: a pressurized reservoir 62 is connected via a first tube 74 with a first valve 76 into the Ø 3 mm central opening 50 of the ball-joint 40. The first tube 74 has to be sealed to the ball-joint 40 via a sealing adapter 76. A second tube 80 having a second valve 82 connects the cavity 70 of the piezoelectric actuator arrangement 10 to a vacuum pump 84 via the sealing adapter 78. Once the cavity 70 in the piezoelectric actuator arrangement 10 is depressurized, the second valve 82 is closed and the first valve 76 is opened so that the potting material 34 is then forced to flow from the pressurized reservoir 62 through the first tube 74 into the cavity 70. An advantage of this filling process is that it does not require any volume control of the potting material 34 dispensed, when creating vacuum inside the cavity 70 of the piezoelectric actuator arrangement 10 prior to the filling from an atmospheric pressurized reservoir 62.

A further advantage of this process is that it permits to use the vacuum / depressurization phase of the filling process to perform a leak check of the encapsulation member 24.

A second process may be used for filling the cavity 70 of piezoelectric actuator arrangement 10 with potting material using vacuum: the piezoelectric actuator arrangement 10 is installed in a pressure chamber which is then depressurized, followed by dispensing of the potting material into the piezoelectric actuator arrangement, followed by re-pressurization to ambient pressure. Such a process is commonly used for ignition coils.

The press-fit of the sealing plug 52 is not sensitive to the presence of any epoxy residues. An axial reaction force will be transmitted through the piezoelectric stack during press-fitting. The piezoelectric stack 36 can tolerate this as long as the force is purely axial with a magnitude less than ≈2kN. The size of the interference fit and the material properties of sealing plug 52 and ball-joint 40 must be selected such that this force level is not exceeded.

An alternative as depicted in Figures 6-8 can be to design the ball-joint piece, in order to provide a fixture to support the press operation reaction force. This will avoid transmitting any axial reaction force through the piezoelectric stack 36 and then will reduce damage risks during the sealing plug press-fit operation.

### Legend:

- 10: actuator arrangement
- 12: body section
- 14: first end piece
- 16: second end piece
- 18: electrical connector
- 20: first terminal
- 22: second terminal
- 24: encapsulation member
- 26: corrugations in a bellows form
- 28: adapter
- 30: first weld
- 32: sealing
- 34: potting material, filler material
- 36: piezoelectric stack chamfered corner of the
- 38: piezoelectric stack
- 40: ball-joint
- 42: collar
- 44: second weld
- 46: third weld
- 48: single weld
- 50: central opening
- 52: sealing plug
- 54: side electrode
- 56: elastomeric disc
- 58: plug sleeve
- 60: groove
- F: pushing and supporting force locations
- 62: pressurized reservoir
- 64: needle
- 66: bended end-tip
- 68: first side hole
- 70: cavity
- 72: second side hole
- 74: first tube
- 76: first valve
- 78: sealing adapter
- 80: second tube
- 82: second valve
- 84: vacuum pump

## Claims

1. An actuator arrangement (10) for use in a fuel injector, comprising:
• a piezoelectric actuator having a body section (12), said body section (12) having a piezoelectric stack (36), a first end piece (14) and a second end piece (16);
• an encapsulation member (24) which encloses the body section (12) between the end pieces (14, 16) secured thereon, wherein potting material (34) is fitted between the encapsulation member (24) and the body section (12), wherein the encapsulation member (24) has a corrugated bellows form comprising a plurality of corrugations (26) over its entire length
wherein said second end piece (16) comprises a ball-joint (40) having a central opening (50) which is sealed after the potting material (34) has been introduced into the encapsulation member (24).

2. The actuator arrangement (10) according to claim 1, wherein the ball-joint (40) is welded to said encapsulation member.

3. The actuator arrangement (10) according to any of the preceding claims, wherein the ball-joint (40) having a central opening (50) is sealed by introducing a sealing plug (52) in the central opening (50) of said ball-joint (40).

4. The actuator arrangement (10) according to claim 3, wherein the sealing plug (52) is press-fitted into the central opening (50) of the ball-joint (40).

5. The actuator arrangement (10) according to claims 3 or 4, wherein the sealing plug (52) comprises an elastomeric disc (56).

6. The actuator arrangement (10) according to claims 3 or 4, wherein the sealing plug (52) comprises a plug sleeve (58).

7. The actuator arrangement (10) according to any of the claims 3 to 6, wherein the sealing plug (52) is additionally secured in the ball-joint (40) by welding.

8. The actuator arrangement (10) according to any of the preceding claims, wherein the encapsulation member (24) comprises a metallic tube made of steel, stainless steel, nickel or one of their alloys.

9. The actuator arrangement (10) according to any of the preceding claims, wherein the encapsulation member (24) has a thickness of between about 0.02 and 0.2 mm preferably of about 0.1 mm.

10. The actuator arrangement (10) according to any of the preceding claims, wherein the potting material (34) is selected from the group consisting of rubber, preferably a silicone or a fluorosilicone rubber, silicone, a polymer preferably a silicone resin or an epoxy resin.

11. The actuator arrangement (10) according to any of the preceding claims, wherein the potting material (34) further comprises >50% w/w of mineral particles.

12. A process for assembling an actuator arrangement (10) for use in a fuel injector comprising:
• a piezoelectric actuator having a body section (12), said body section (12) having a piezoelectric stack (36), a first end piece (14) and a second end piece (16);
• an encapsulation member (24) which encloses the body section (12) between the end pieces (14, 16) secured thereon, wherein the encapsulation member (24) has a corrugated bellows form comprising a plurality of corrugations (26) over its entire length
• said second end piece (16) comprises a ball-joint (40) having a central opening (50)
wherein potting material (34) is filled through the central opening (50) of said second end piece (16) between the encapsulation member (24) and the body section (12) and
wherein the central opening (50) is sealed after the potting material (34) has been introduced into the encapsulation member (24).

13. The process according to claim 12, wherein the potting material (34) is introduced between the encapsulation member (24) and the body section (12) through the central opening (50) of the second end piece (16) and through a first side hole (68) in the second end piece (16) whereas gas escapes or is withdrawn from a second side hole (72) in the second end piece (16).

14. The process according to claim 12, wherein a pressurized reservoir (62) containing a potting material (34) is connected via a first tube (74) having a first valve (76) to the central opening (50) of the second end piece (16), a vacuum pump (84) is connected via a second tube (80) having a second valve (82) to the central opening (50) of the second end piece (16), wherein in a first step, said first valve (76) is closed and said second valve (80) is opened and gas contained in the piezoelectric actuator arrangement is withdrawn from the piezoelectric actuator arrangement, wherein in a second step, said second valve (82) is closed and said first valve (76) is opened so that the potting material (34) contained in said reservoir (62) is transferred through said central opening (50) in the second end piece (16) in a space contained between the encapsulation member (24) and the body section (12).

15. The process according to claim 12, wherein the piezoelectric actuator arrangement 10 is transferred in a pressure chamber which is then depressurized, the potting material (34) is dispensed into the piezoelectric actuator arrangement between the encapsulation member (24) and the body section (12) and wherein the piezoelectric actuator arrangement (10) is then re-pressurized to ambient pressure and transferred out of the pressure chamber.
